(19) Europäisches Patentamt
European Patent Office
Office européen des brevets

(11) **EP 1 834 162 B1**

(12) **EUROPÄISCHE PATENTSCHRIFT**

(45) Veröffentlichungstag und Bekanntmachung des Hinweises auf die Patenterteilung:
**11.03.2009 Patentblatt 2009/11**

(21) Anmeldenummer: **06705760.4**

(22) Anmeldetag: **04.01.2006**

(51) Int Cl.:
***G01J 5/40*** *(2006.01)*

(86) Internationale Anmeldenummer:
**PCT/DE2006/000016**

(87) Internationale Veröffentlichungsnummer:
**WO 2006/072237 (13.07.2006 Gazette 2006/28)**

(54) **MIKROSYSTEMTECHNISCHES BAUELEMENT MIT EINER UNTER DEM EINFLUSS VON TEMPERATURÄNDERUNGEN VERFORMBAREN EINRICHTUNG**

MICROSYSTEM COMPONENT WITH A DEVICE DEFORMABLE UNDER THE INFLUENCE OF TEMPERATURE CHANGES

COMPOSANT DE LA TECHNIQUE DES MICROSYSTEMES, POURVU D'UN DISPOSITIF DEFORMABLE SOUS L'EFFET DE VARIATIONS DE TEMPERATURE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **05.01.2005 DE 102005001116**

(43) Veröffentlichungstag der Anmeldung:
**19.09.2007 Patentblatt 2007/38**

(73) Patentinhaber: **Universität Kassel
34125 Kassel (DE)**

(72) Erfinder:
• **RANGELOW, Ivo
34225 Baunatal (DE)**
• **IVANOV, Tzvetan
98693 Ilmenau (DE)**
• **IVANOVA, Katerina
98693 Ilmenau (DE)**

(74) Vertreter: **Freiherr von Schorlemer, Reinfried
Karthäuser Straße 5A
D-34117 Kassel (DE)**

(56) Entgegenhaltungen:
**WO-A-00/40938          US-A1- 2001 052 570**

**Beschreibung**

Die Erfindung betrifft ein mikrosystemtechnisches Bauelement der im Oberbegriff des Anspruchs 1 angegebenen Gattung.

Bekannte Bauelemente dieser Art enthalten als verformbare Einrichtung einen nach Art eines Bimetallstreifens ausgebildeten Biegebalken (Cantilever). Dieser ist mit seinem einen Ende fest an einem Haltekörper fixiert, während sein anderes Ende frei beweglich angeordnet ist. In Abhängigkeit von den Temperaturverhältnissen nimmt der Biegebalken einen mehr oder weniger stark gekrümmten Biegezustand ein.

Als Wärmequellen für ein derartiges Bauelement dienen z. B. elektromagnetische Strahlungen, insbesondere in Form von nachfolgend kurz als IR-Strahlen bezeichneten Infrarot- bzw. Wärmestrahlen (z. B. WO 00/40938, US 2001/0052570 As, US 6 805 839 B2 und P. G. Datskos, N. V. Lavrik, S. Rajic in "Performance of uncooled microcantilever thermal detectors", Review of Scientific Instruments, Vol. 75, No. 4, April 2004, Seiten 1134 bis 1148). Das Bauelement dient in diesem Fall als IR-Sensor, vorzugsweise für Wellenlängenbereiche von 1 $\mu$m bis 20 $\mu$m, obwohl die Anwendung derartiger Sensoren nicht auf bestimmte Wellenlängenbereiche beschränkt ist. Die Wirkungsweise des Bauelements besteht dabei darin, dass die durch Absorption der Strahlung bewirkte Erwärmung des Biegebalkens zu einer charakteristischen Verbiegung führt, die als Maß für die aufgenommenen Wärmemenge dienen kann. Derartige Sensoren finden vor allem in der Elektroindustrie, in Form von Cantilever-Arrays in IR-Kameras und im Militärbereich, aber z. B. auch in der Medizin, in der Bautechnik oder in der Forschung breite Anwendung. Ihr besonderer Vorteil besteht darin, dass sie im Gegensatz zu anderen IR-Sensoren ohne spezielle Kühlung angewendet werden können.

Bei einer anderen Anwendungsart ist das beschriebene Bauelement als Mikroaktuator eingerichtet (z. B. WO 00/40938, DE 103 07 561 A1). Das Bauelement ist zu diesem Zweck z. B. mit einer Wärmequelle in Form eines elektrischen Heizelements versehen. Seine Wirkungsweise besteht in diesem Fall darin, dass durch das Hindurchleiten eines elektrischen Stroms durch das Heizelement eine kontrollierte lokale Erwärmung im Biegebalken erzeugt und dadurch ein vorgewählter Biegezustand erzwungen wird.

Derartige Aktuatoren werden z. B. in Verbindung mit atomaren, nach dem AFM-Verfahren arbeitenden Kraftmikroskopen (AFM = Atomic Force Microscopy) angewendet und/oder zur kombinierten Abtastung und Untersuchung von mikrotechnischen, elektrische Kontakte aufweisenden Bauelementen eingesetzt.

Auch andere Anwendungen im mikro-elektrischen-optischen-mechanischen Bereich sind möglich.

Die bekannten, nach Art von Bimetallstreifen aufgebauten Biegebalken sind im Hinblick auf ihre Empfindlichkeit, ihre Ansprechgeschwindigkeit und ihre thermische Isolierung nicht voll zufriedenstellend. Ein Hauptgrund hierfür besteht darin, dass bei vielen geeigneten Materialien der thermische Ausdehnungskoeffizient und die Wärmeleitfähigkeit entweder beide verhältnismäßig groß oder beide verhältnismäßig klein sind. Das hat zur Folge, dass eine in gewünschter Weise große Differenz zwischen den thermischen Ausdehnungskoeffizienten der beteiligten Materialien gleichzeitig mit einer hohen Wärmeleitung wenigstens eines der beiden Materialien verbunden ist, was zu einem schnellen Abfluss der aufgenommenen Wärme führt und entweder aufwendige Isolationsmaßnahmen erfordert oder die Empfindlichkeit und die Ansprechgeschwindigkeit beeinträchtigt. Problematisch ist dies insbesondere bei Anwendungen, bei denen wie z. B. in IR-Kameras eine Vielzahl derartiger Bauelemente beteiligt ist.

Das von der Erfindung zu lösende technische Problem besteht daher darin, das Bauelement der eingangs bezeichneten Gattung so auszubilden, dass es einerseits eine hohe Empfindlichkeit besitzt, keine aufwendigen Isolierungen erfordert und schnell auf Temperaturänderungen anspricht, andererseits aber dennoch preisgünstig herstellbar ist und keine Kühlung erfordert.

Gelöst wird dieses Problem durch die Merkmale des Anspruchs 1.

Während bei bisherigen Bauelementen die verformbare Einrichtung durchweg einen nach Art eines Schichtenkörpers ausgebildeten Biegebalkens enthält, in dem die unterschiedliche thermische Ausdehnungskoeffizienten aufweisende Materialien übereinander angeordnete Schichten bilden, schlägt die Erfindung einen davon abweichenden Aufbau der verformbaren Einrichtung vor. Die räumliche Trennung der die Verformung bewirkenden Materialien führt zu einem vollkommen neuen Design, das andere Geometrien und eine bessere thermische Isolierung ermöglicht. Außerdem kann die verformbare Einrichtung in Form eines extrem dünnen, strukturierten Chips hergestellt werden, was die Ansprechgeschwindigkeit verbessert. Außerdem ermöglicht das neue Design ohne wesentliche Konstruktions- und/oder Kostennachteile sowohl eine zusätzliche Integration von zur Messung der Verformung bestimmten Detektoren als auch eine einfache Einstellung des Bauelements auf einen vorgewählten Wellenlängenbereich.

Weitere vorteilhafte Merkmale der Erfindung ergeben sich aus den Unteransprüchen.

Die Erfindung wird nachfolgend in Verbindung mit den beiliegenden Zeichnungen an Ausführungsbeispielen näher erläutert. Es zeigen:

Fig. 1 eine schematische Draufsicht auf ein erfindungsgemäßes, mikrosystemtechnisches Bauelement in Form eines IR-Sensors;

Fig. 2 eine vergrößerte Draufsicht insbesondere auf eine unter dem Einfluss von Temperaturänderungen verformbare Einrichtung nach Fig. 1;

Fig. 3 einen vergrößerten Längsschnitt durch die verformbare Einrichtung längs der Linie m - III der Fig. 2;

Fig. 4 bis 6 vergrößerte Querschnitte durch die verformbare Einrichtung längs der Linien IV - IV bis VI - VI der Fig. 2;

Fig. 7 eine stark vergrößerte Einzelheit X der Fig. 6;

Fig. 8 einen vergrößerten Schnitt durch die verformbare Einrichtung längs der Linie VIII - VIII der Fig. 2;

Fig. 9 in einer schematischen, perspektivischen Darstellung das Wirkungsprinzip der verformbaren Einrichtung nach Fig. 1 bis 8;

Fig. 10 eine schematische Draufsicht auf ein erfindungsgemäßes, mikrosystemtechnisches Bauelement in Form eines Aktuators;

Fig. 11 bis 19 anhand schematischer Draufsichten und Schnittdarstellungen die Herstellung des Bauelements nach Fig. 1 bis 9;

Fig. 20 und 21 ein zweites Ausführungsbeispiel des erfindungsgemäßen Bauelements in perspektivischen Ansichten; und

Fig. 22 eine Draufsicht auf ein drittes Ausführungsbeispiel der Erfindung.

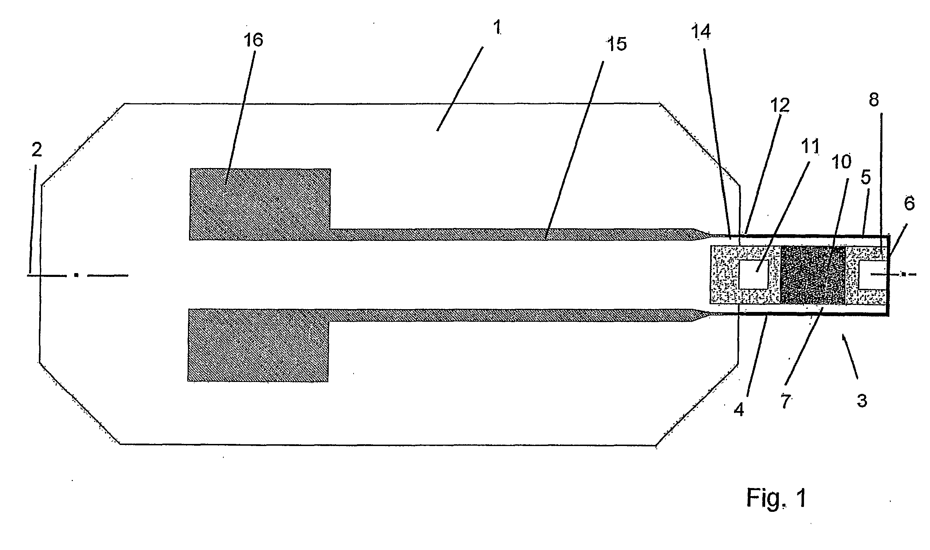

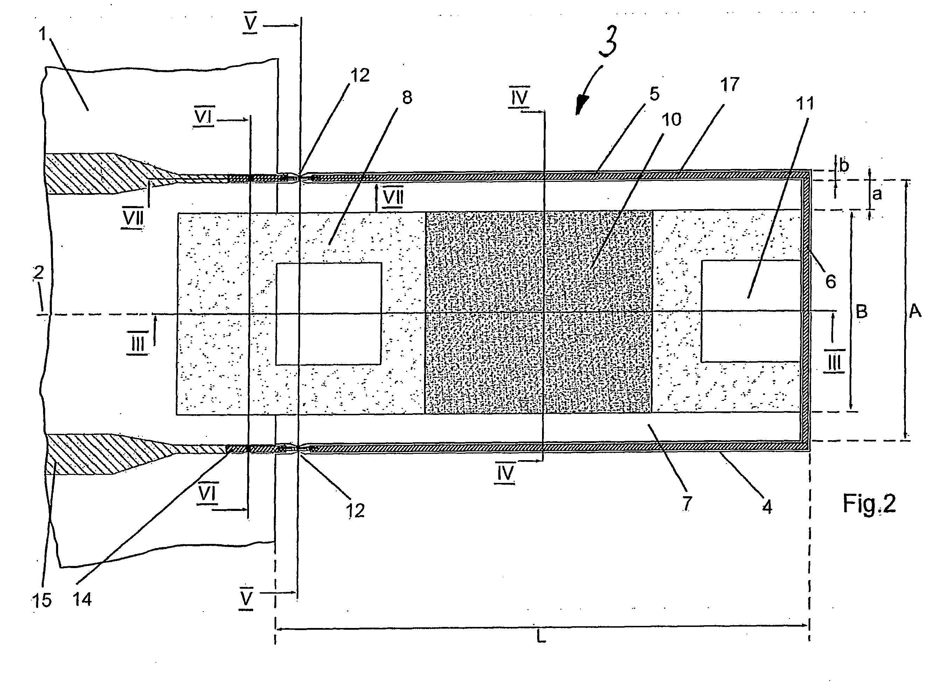

Das in Fig. 1 dargestellte, mikrosystemtechnische Bauelement der vorliegenden Erfindung enthält einen Grund- und Haltekörper 1 mit einer Längsachse 2. An einem Längsende des Grundkörpers 1 ist ein Längsende einer insbesondere aus Fig. 2 ersichtlichen, verformbaren Einrichtung 3 starr befestigt, deren anderes, in Richtung der Längsachse 2 vom Grundkörper 1 abgewandtes Längsende frei bewegbar angeordnet ist. Die Einrichtung 3 und damit das gesamte Bauelement ist im Ausführungsbeispiel als ein Sensor für eine elektromagnetische Strahlung, insbesondere für IR-Strahlung eingerichtet und zu diesem Zweck so ausgebildet, dass die durch die Stahlung am Ort des Bauelements bewirkten Temperaturänderungen gemessen werden können.

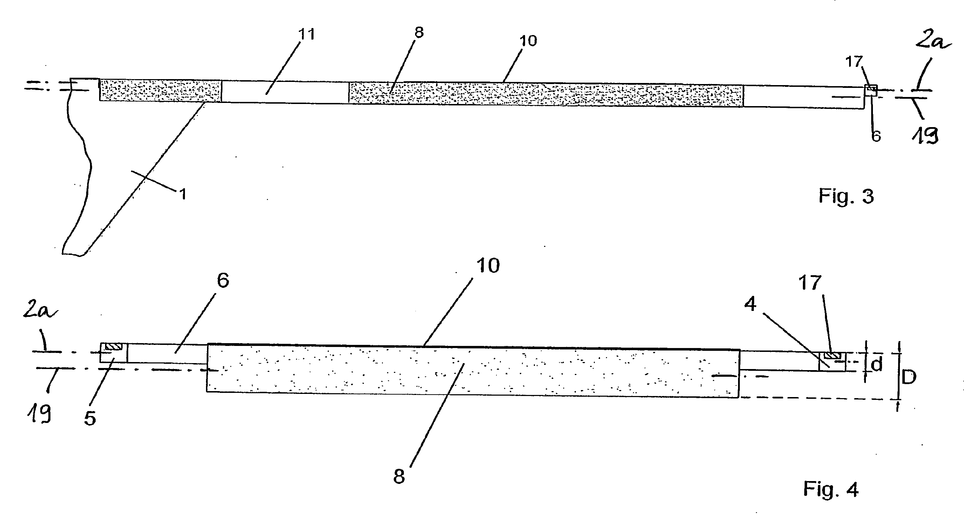

Die Einrichtung 3 enthält wenigstens ein erstes, biegbares Element 4 in Form eines vergleichsweise schmalen, länglichen Materialstreifens oder -stegs, der zweckmäßig parallel zur Längsachse 2 angeordnet ist. Vorzugsweise ist wie im Ausführungsbeispiel ein weiteres erstes biegbares Element 5 vorgesehen, das zweckmäßig mit einem vorgewählten Abstand und parallel zum Element 4 angeordnet und wie dieses ausgebildet ist. Die Elemente 4 und 5 sind an ihren einen, in Fig. 2 linken Enden starr am Grundkörper 1 fixiert. Die davon entfernten anderen Enden der Elemente 4 und 5 sind dagegen mit einem Endabschnitt 6 fest verbunden, der zweckmäßig aus demselben Material und mit derselben Querschnittsform und -größe wie die Elemente 4, 5 ausgebildet ist. Aufgrund dieser Konstruktion bilden die Elemente 4, 5 und der Endabschnitt 6 zusammen mit dem zugehörigen Längsende des Grundkörpers 1 einen Rahmen, der eine Öffnung 7 umgibt und eine die Längsachse 2 (Fig. 2) einschließende, in Fig. 3 und 4 im wesentlichen senkrecht zur Zeichenebene angeordnete Mittelebene 2a besitzt. Der Rahmen ist gemäß Fig. 1 und 2 in der Draufsicht im wesentlichen rechteckförmig, doch sind natürlich auch andere Rahmenformen möglich.

Die Einrichtung 3 enthält ferner wenigstens ein zweites, ebenfalls biegbares Element 8, das zwischen den beiden ersten Elementen 4, 5 und vorzugsweise wie diese parallel zur Längsachse 2 angeordnet ist und die Öffnung 7 auf deren ganzer Länge parallel zur Längsachse 2 überspannt. Ein Ende dieses zweiten Elements 8 ist starr am Grundkörper 1 fixiert, während sein anderes Ende fest mit dem Endabschnitt 6 verbunden ist. Dabei sind einerseits die Abmessungen gemäß Fig. 2 so gewählt, dass das zweite Element 8 eine quer zur Längsachse 2 gemessene Breite B aufweist, die überall kleiner als ein lichter Abstand A zwischen den beiden Elementen 4 und 5 ist. Andererseits ist das zweite Element 8 so zwischen den beiden ersten Elementen 4 und 5 angeordnet, das sowohl zwischen den Elementen 4 und 8 als auch zwischen den Elementen 5 und 8 überall ein lichter Abstand a vorhanden ist, der ein vorgewähltes Maß nicht unterschreitet. Außerdem besitzt das zweite Element 8 vorzugsweise eine wesentliche größere, z. B. mehr als 10-fache Breite B, als der ebenfalls senkrecht zur Längsachse 2 gemessenen Breite b jedes ersten Elements 4, 5 entspricht, so dass es insgesamt etwa die Form einer planparallelen Platte hat. Dadurch sind die ersten Elemente 4, 5 wesentlich leichter verbiegbar als das zweite Element 8. Schließlich ist klar, dass das zweite Element 8 auch aus mehreren, parallel zur Längsachse 2 angeordneten und entsprechend schmaleren Abschnitten bestehen könnte, ohne dadurch den lichten Abstand a zu verändern.

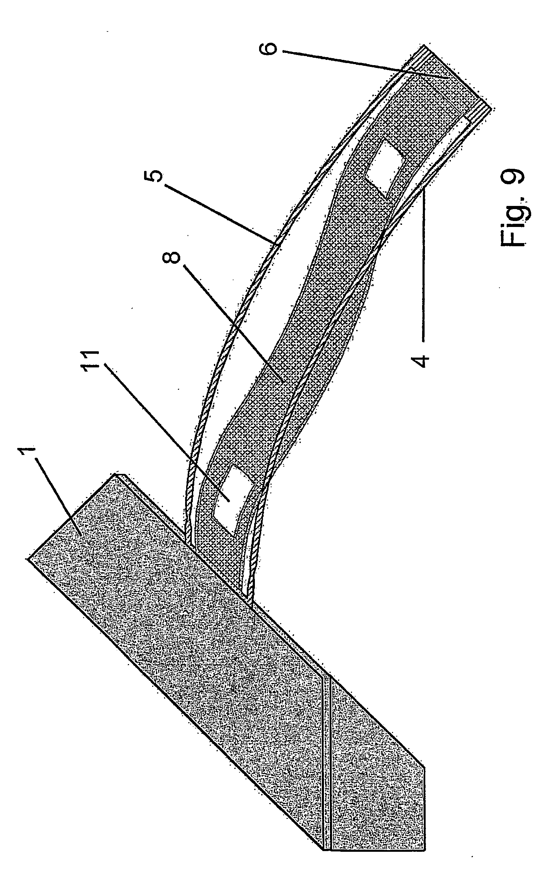

Die ersten und zweiten Elemente 4, 5 und 8 besitzen unterschiedliche thermische Ausdehungskoeffizienten und Wärmeleitfähigkeiten. Dadurch wird der Vorteil erzielt, dass sich unabhängig von den im Einzelfall gewählten Abmessungen der Elemente 4, 5 und 8 eine hohe Ansprechempfindlichkeit für die Einrichtung 3 erzielen lässt. Vorzugsweise ist der Ausdehnungskoeffizient der ersten Elemente 4, 5 wesentlich kleiner als der des zweiten Elements 8. Dagegen ist es im Hinblick die Wärmeleitfähigkeit vorzugsweise umgekehrt, d. h. das zweite Element 8 besitzt eine wesentlich kleinere Wärmeleitfähigkeit als die ersten Elemente 4 und 5. Wird daher das zweite Element 8 z. B. durch Absorption einer IR-Strahlung erwärmt, dann dehnt es sich im Vergleich zu den Elementen 4, 5 parallel zur Längsachse 2 wesentlich stärker als die Elemente 4, 5 aus. Da das zweite Element 8 jedoch einerseits starr am Grundkörper 1 fixiert und andererseits fest mit dem auch an den ersten Elementen 4, 5 befestigten Endabschnitt 6 verbunden ist, wird diese lineare Ausdehnung in eine entsprechende Verbiegung aller vorhandenen Elemente 4, 5 und 8 umgewandelt, wie schematisch in Fig. 9 gezeigt ist. Da die ersten Elemente 4, 5 auch am Grundkörper 1 starr fixiert sind, werden sie sich dabei im wesentlichen kontinuierlich nach der einen oder anderen Seite hin verformen, während gleichzeitig das zweite Element 8 in sich wellenförmig verformt wird, wodurch der Endabschnitt 6 eine entsprechende Auslenkung senkrecht zu einer vorgewählten Nullebene erfährt, die z. B. durch die Mittelebene 2a gebildet wird, die die Längsachse 2 enthält.

Ein wesentlicher Vorteil der beschriebenen Einrichtung 3 besteht darin, dass das zweite Element 8 durch die lichten Abstände a räumlich von den ersten Elementen 4, 5 getrennt ist. Da außerdem das zweite Element 8 eine nur geringe Wärmeleitfähigkeit hat, kann von ihm aufgenommene Wärme nicht ohne weiteres zum Grundkörper 1 abfließen, selbst wenn dieser und/oder die ersten Elemente 4, 5 und/oder der Endabschnitt 6 aus einem vergleichsweise gut wärmeleitenden Material wie z. B. Silicium bestehen. Auch ein Wärmeabfluss über die schmalen Elemente 4, 5 und den Endabschnitt 6, der vorzugsweise genauso schmal wie die Elemente 4, 5 ausgebildet wird, ist zumindest stark gehemmt.

Mit besonderem Vorteil wird das zweite Element 8 auf einer zur Aufnahme der Strahlung bestimmten Breitseite außerdem mit einem gut wärmeleitenden Absorber 10 belegt, der die Strahlung absorbiert und die erzeugte Wärme dem zweiten Element 8 breitflächig zuführt, wodurch dieses gedehnt wird. Der Absorber 10 ist - in Richtung der Längsachse 2 betrachtet - vorzugsweise in einem mittleren Bereich des zweiten Elements 8 angeordnet. Um zu vermeiden, dass die aufgenommene Wärme trotz der schlechten Wärmeleitfähigkeit des zweiten Elements 8 und trotz der Spalte mit der Breite a zum Grundkörper 1 und/oder zum Endabschnitt 6 abfließt, ist das zweite Element 8 weiterhin zweckmäßig mit wenigstens einem Loch 11 versehen, das in einem Bereich ausgebildet ist, der zwischen dem Absorber 10 und dem Grundelement 1 oder dem Absorber 10 und dem Endabschnitt 6 angeordnet ist. Auf diese Weise wird eine sehr gute thermische Isolierung des zweiten Elements 8 gegenüber den restlichen Teilen der Einrichtung 3 erzielt und sichergestellt, dass die aufgenommene Strahlung bzw. Wärme optimal in eine Längendehnung des Elements 8 umgesetzt wird.

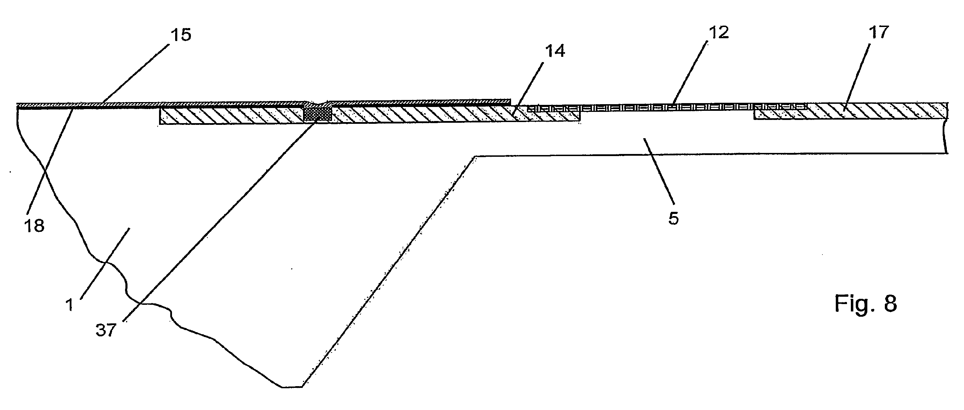

Die Messung der Verformung bzw. Verbiegung der Einrichtung 3 bzw. der Elemente 4, 5 bzw. 8 kann prinzipiell auf verschiedene Arten vorgenommen werden, z. B. mit optischen oder kapazitiven Mitteln. Erfindungsgemäß wird vorgeschlagen, die Auslenkung der ersten Elemente 4, 5 bzw. des von diesen gebildeten Rahmens mit Hilfe von piezoresistiven Detektoren zu messen. Zu diesem Zweck ist in wenigstens einem der ersten Elemente 4 und 5, vorzugsweise jedoch gemäß Fig. 2 in beiden ersten Elementen 4 und 5 je ein piezoresistiver Detektor 12 eingebaut (vgl. auch Fig. 8). Der Detektor 12 ist zweckmäßig nahe dem festliegenden Ende des jeweiligen Elements 4, 5 vorgesehen. Mit einem solchen Detektor 12 lässt sich u. a. die lokal auf das jeweilige Element 4, 5 wirkende mechanische Spannung berechnen, da sich der Widerstand des Detektors 12 nach der Formel

$$\Delta R/R = \delta_l \, \Pi_l + \delta_t \, \Pi_t$$

ändert. Darin bedeuten R den Widerstand des Detektors 12, $\Delta R$ die Widerstandsänderung, $\delta_1$ und $\delta_t$ die laterale bzw. transversale Spannungskomponente und $\Pi_l$ und $\Pi_t$ die transversalen bzw. lateralen, piezoresistiven Koeffizienten (vgl. z. B. Reichl et al in "Halbleitersensoren", expert-Verlag 1989, S. 225). Vorzugsweise ist der Detektor 12 an einem Ort des Elements 4, 5 angeordnet, wo sich die höchsten mechanischen Spannungen ergeben, um ein hohes Signal/Rausch-Verhältnis zu erhalten.

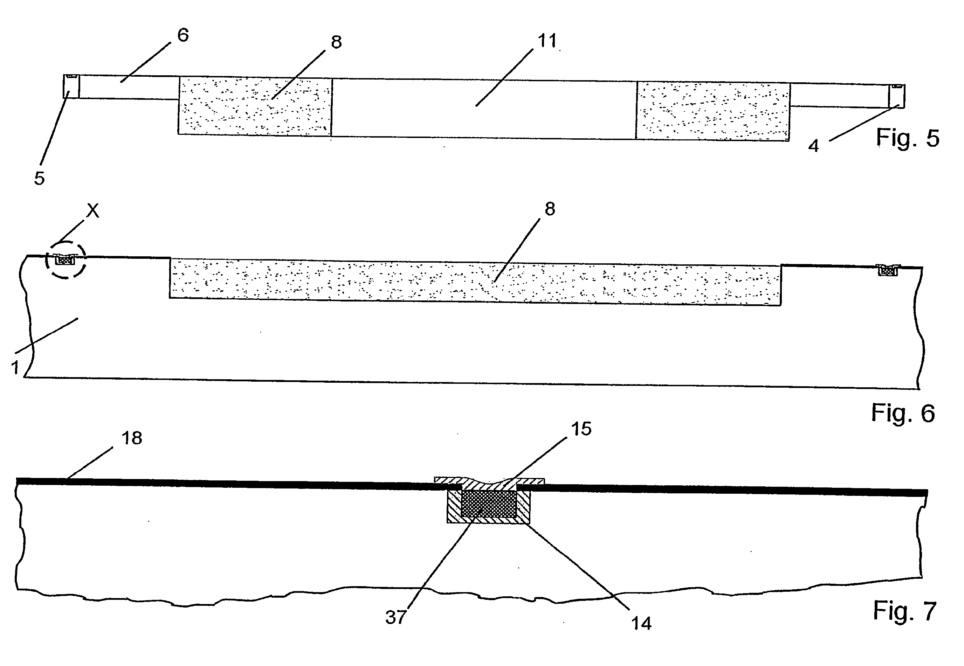

Gemäß Fig. 1, 2 und 8 sind die beiden Detektoren 12 in Reihe geschaltet. Zu diesem Zweck ist einerseits der eine Anschluss jedes Detektors 12 mit einer bis zum Grundkörper 1 erstreckten elektrischen Leitung 14 verbunden, die an eine auf der Oberseite des Grundkörpers 1 verlegte Leiterbahn 15 angeschlossen ist, die zu einer ebenfalls auf der Oberfläche des Grundkörpers 1 angeordneten Kontaktfläche (pad) 16 (Fig. 1) führt. Andererseits sind die anderen Enden der beiden Detektoren 12 mittels einer elektrischen Leitung 17 (Fig. 2 und 8) miteinander verbunden. Die Leitungen 14 und 17 sind dabei vorzugsweise auf der oberen Breitseite des Grundkörpers 1 sowie der Elemente 4, 5 und des Endabschnitts 6 verlegt bzw. in diese eingelassen. Außerdem sind die Leitungen 14, 15 und 17 sowie die Kontaktflächen 16 sowohl gegeneinander als auch gegen andere leitende Teile des Bauelements elektrisch isoliert angeordnet bzw. ausgebildet. Hierzu ist z. B. gemäß Fig. 7 und 8 zwischen der Leitung 14 und der Leiterbahn 15 eine Schicht 18 aus Siliciumnitrid ($Si_3N_4$) vorgesehen, durch die die Leitungen 14, 15 miteinander verbunden sind.

Zur Verbesserung der Empfindlichkeit bei der Messung der Biegezustände der Elemente 4, 5 sind diese dort, wo die piezoresistiven Detektoren 12 angeordnet sind, zweckmäßig mit reduzierten Querschnitten versehen, wie insbesondere Fig. 2 deutlich zeigt.

Ein wichtiger Vorteil der beschriebenen Messvorrichtung besteht darin, dass sie neben der räumlichen Trennung auch eine Trennung der Funktionen ermöglicht. Während das zweite Element 8 insbesondere der Strahlungsabsorption und der linearen Dehnung dient, werden die ersten Elemente 4, 5 hauptsächlich zum Nachweis und zur Messung der Verformung der ersten Elemente 4, 5 bzw. des von diesen gebildeten Rahmens quer zur Mittelebene 2a bzw. in Richtung ihrer Dicke d benutzt. Daher können die ersten und zweiten Elemente 4, 5 und 8 entsprechend ihren Funktionen optimiert werden, ohne dass sie sich gegenseitig störend beeinflussen.

Die beschriebenen Teile des Bauelements können aus zahlreichen unterschiedlichen Materialien hergestellt werden. Bei einem besonders effektiven und derzeit als am besten empfundenen Ausführungsbeispiel bestehen der Grundkörper 1, die ersten Elemente 4, 5 und der Endabschnitt 6 aus einem einstückig hergestellten Siliciumchip. Dagegen besteht das zweite Element aus einem Polymer (Epoxidharz), das allgemein unter dem Warenzeichen "SU-8" bekannt ist und bisher überwiegend als Fotolack (Photoresist) in der Fotolithografie verwendet wird (vgl. US-PS 4 882 245). Erfindungsgemäß wird der Umstand genutzt, dass Silicium einen vergleichsweise geringen thermischen Ausdehnungskoeffizienten ($\alpha \approx 2{,}61 \cdot 10^{-6} \cdot K^{-1}$) und eine verhältnismäßig hohe Wärmeleitfähigkeit hat ($k \approx 148$ W/mK), während das Material SU-8 einen vergleichsweise großen thermischen Ausdehnungskoeffizienten ($\alpha \approx 52 \cdot 10^{-6} \cdot K^{-1}$), aber eine äußerst geringe Wärmeleitfähigkeit besitzt ($k \approx 0{,}2$ W/mK). Schließlich wird als Material für den Absorber 10 vorzugsweise Gold benutzt, dessen Wärmeleitfähigkeit mit $k \approx 314$ W/mK sehr hoch ist, so dass die aufgenommene Strahlungswärme sehr schnell an das zweite Element 8 weitergeleitet wird. Die thermische Ausdehnung des Absorbers 10 ist hier weniger bedeutsam. Ein weiterer Vorteil besteht schließlich darin, dass das SU-8 hergestellte Element 8 mit einer vergleichsweisen großen Dicke von z. B. 10 $\mu$m bis 20 $\mu$m hergestellt werden kann, so dass es massiv und stabil ist.

Die verschiedenen Teile der beschriebenen Einrichtung 3 sind vorzugsweise wie folgt dimensioniert (die gewählten Bezeichnungen ergeben sich aus Fig. 2 und 4):

1. Dicke d der ersten Elemente 4, 5 und des Endabschnitts 6 ca. 1 $\mu$m bis 7 $\mu$m;

2. Dicke D des zweiten Elements 8 ca. 2 $\mu$m bis 10 $\mu$m;

3. Breite b der ersten Elemente 4, 5 und des Endabschnitts 6 ca. 10 $\mu$m bis 15 $\mu$m;

4. Breite B des zweiten Elements 8 ca. 200 $\mu$m;

5. Breite a der Luftspalte zwischen den ersten Elementen 4, 5 und dem zweiten Element 8 ca. 5 $\mu$m bis 15 $\mu$m;

6. Länge L der Einrichtung 3 ab Grundkörper 1 ca. 550 $\mu$m.

Mit einer derartigen Einrichtung 3 wurden Auslenkungen des Endabschnitts 6 bis zu ca. 2 $\mu$m pro 1 ° K bei einer Empfindlichkeit von 1 $\mu$V pro 1 nm Auslenkung gemessen. Dadurch, dass die ersten Elemente 4, 5 dünner als das zweite Element 8 ausgebildet werden und eine Mittelebene 19 des zweiten Elements 8 mit Abstand von der Mittelebene 2a der ersten Elemente 4, 5 bzw. des von diesen gebildeten Rahmens angeordnet wird (Fig. 3 und 4), ist es möglich, die Verbiegung in eine bevorzugte Richtung erfolgen zu lassen (in Fig. 3 z. B. senkrecht nach oben).

Bei der Herstellung von 2D-Arrays, beispielsweise für IR-Kameras, können die angegebenen Maße erheblich reduziert werden, um eine verformbare Einrichtung 3 mit den Gesamtabmessungen Länge ca. 100 $\mu$m, Breite ca. 20 $\mu$m und Dicke ca. 1 $\mu$m zu erhalten.

Ist es erwünscht, den beschriebenen IR-Sensor selektiv auf einen bestimmten Wellenlängenbereich einzustellen, kann dies z. B. durch Auswahl des Absorbermaterials erfolgen, indem z. B. Aluminiumnitrid (A1N) oder Siliciumnitrid ($SiN_x$) anstelle der für Breitbandzwecke geeigneten Goldbeschichtung verwendet wird. Hierdurch ist es z. B. möglich, den IR-Sensor auf kleine Wellenlängenbereiche innerhalb eines Gesamtbereichs von 1 $\mu$m bis 20 $\mu$m einzustellen und z. B. auf IR-Bildern Tiere von Menschen zu unterscheiden.

Auch für die ersten und zweiten Elemente 4, 5 und 8 sind prinzipiell andere Materialien geeignet, z. B. zwei Metalle mit entsprechend unterschiedlichen Ausdehnungskoeffizienten und Wärmeleitfähigkeiten. Insbesondere könnte anstelle SU-8 für das zweite Element 8 auch Aluminium oder $SiN_x$ verwendet werden. Allerdings weist Aluminium neben einer guten Wärmedehnung eine hohe Wärmeleitfähigkeit auf, was unerwünscht ist, während $SiN_x$ zwar eine geringere Wärmeleitfähigkeit, aber eine unerwünscht geringe Wärmedehnung hat. Das Material SU-8 besitzt demgegenüber eine hohe Wärmedehnung und gleichzeitig eine geringe Wärmeleitfähigkeit.

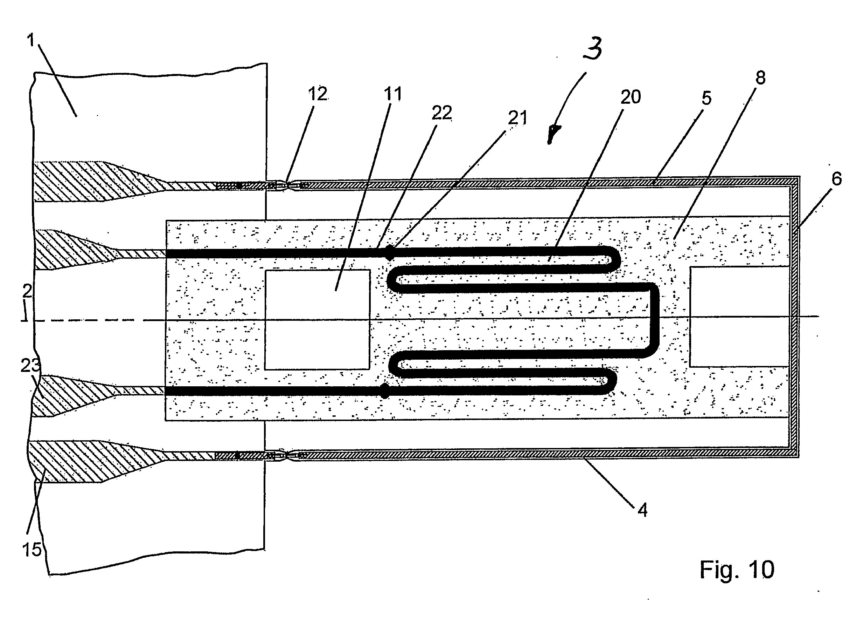

Fig. 10 zeigt schematisch ein Bauelement, das im wesentlichen dem Bauelement nach Fig. 1 bis 9 entspricht, jedoch als Aktuator ausgebildet ist. Im Unterschied zu Fig. 1 bis 9 ist das zweite Element 8 der Einrichtung 3 hier nicht mit einem Absorber 10, sondern mit einem elektrischen Heizelement 20 belegt, das zwei Anschlüsse 21 aufweist, die über elektrische Leitungen 22, die auf der Oberseite des zweiten Elements 8 angeordnet sind, mit elektrischen Leiterbahnen 23 verbunden sind, die auf der oberen Breitseite des Grundkörpers 1 vorgesehen werden und zu ebenfalls auf der Oberfläche des Grundkörpers 1 angeordneten, nicht dargestellten Kontaktflächen führen. Die Leiterbahnen 23 und Kontaktflächen entsprechen im wesentlichen den Leiterbahnen 15 und Kontaktflächen 16 für die Detektoren 12, sind gegenüber diesen aber elektrisch isoliert angebracht. Dadurch, dass von außen her ein elektrischer Strom durch das Heizelement 20 geleitet wird, kann die Einrichtung 3 kontrolliert und aktiv verformt werden. Das Heizelement 20 besteht z. B. aus einem Widerstandsheizelement oder einem gestreckten oder wendelförmig verlegten Heizdraht od. dgl., der beim Durchleiten eines elektrischen Stroms eine lokale Erwärmung des zweiten Elements 8 bewirkt. Außerdem kann das Element 8 in diesem Fall mit einer nicht gezeigten, für Cantilever-Anwendungen typischen Spitze versehen werden (vgl. DE 103 07 561 A1).

Die Leiterbahnen 15, 23 und die Kontaktflächen 16 werden vorzugsweise aus einem gut leitenden Material wie z. B. Aluminium, Gold, Titan oder Legierungen davon hergestellt und auf der Oberfläche des Grundkörpers 1 angebracht, der vorzugsweise aus einem zusammen mit den ersten Elementen 4, 5 einstückig hergestellten Siliciumkörper besteht, der mit einer Schutzschicht aus Siliciumdioxid ($SiO_2$) versehen sein kann. Die Leitungen 14, 17 sind vorzugsweise in der Oberfläche der ersten Elemente 4, 5 versenkt angeordnet und z. B. aus stark p-leitenden Zonen (p+) im Siliciumgrundmaterial hergestellt. Das Heizelement 20 und die Leitungen 22 können aus einem in das Element 8 integrierten Mikrodraht aus Aluminium od. dgl. bestehen.

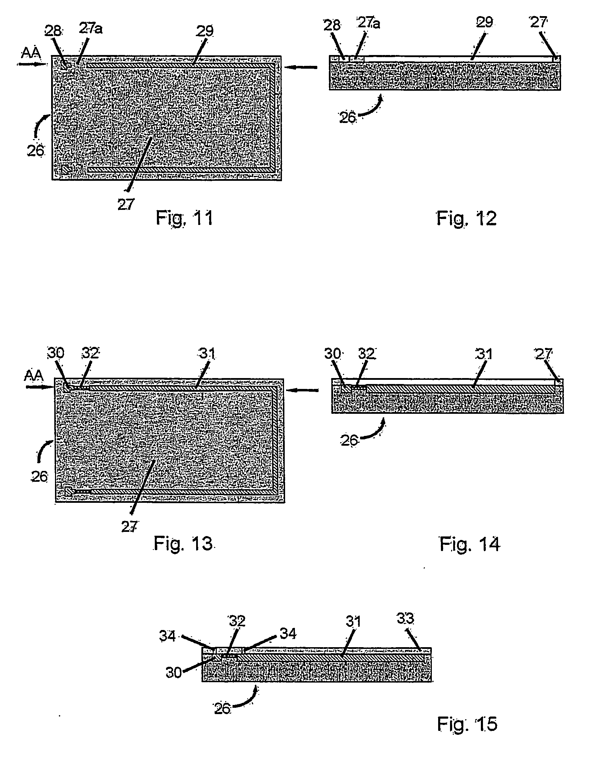

Die Herstellung der beschriebenen Bauelemente ist schematisch in Fig. 11 bis 19 angedeutet und kann mit den bei der mikrosystemtechnischen Cantilever-Herstellung bekannten Verfahren erfolgen [z. B. T. Gotszalk, J. Radojewski, P. B. Grabiec, P. Dumalia, F. Shi, P. Hudek und I. W. Rangelow in "Fabrication of multipurpose piezoresistive Wheatstone bridge cantilevers with conductive microtips for electrostatic and scanning capacitance microscopy", J. Vac. Sci. Technol. B 16(6), Nov/Dec 1998, Seiten 3948 bis 3953 oder I. W. Rangelow, P. B. Grabiec, T. Gotszalk und K. Edinger in "Piezoresistive SXM Sensors", SIA 1162, 2002, Seiten 3948 bis 3953]. Als Ausgangsmaterial wird gemäß Fig. 11 und 12 vorzugsweise eine beidseitig polierte, n-leitende Siliciumwafer bzw. -scheibe 26 verwendet, deren planparallele Breitseiten als (100)-Flächen ausgebildet sind und die zunächst zumindest auf ihrer oberen Breite mit einer thermisch aufgebrachten $SiO_2$-Schutzschicht 27 versehen ist. Die Bearbeitung der Siliciumscheibe 26 erfolgt z. B. nach der sog. MESA-Technik.

Im Ausführungsbeispiel werden zunächst in die auf der oberen Breitseite befindliche Schutzschicht 27 mit üblichen Lithografie- und Ätzverfahren Fenster 28, 29 eingearbeitet (Fig. 11 und 12). Durch die Fenster 28, 29 hindurch wird dann mit hoher Dotierung z. B. Bor in die Siliciumscheibe 26 diffundiert oder durch Ionenimplantation eingebracht, um unterhalb der Fenster 28, 29 p+-leitende Schichten 30, 31 (Fig. 13, 14) zu erzeugen, die die Leitungen 14 und 17 in Fig. 7 und 8 bilden sollen. In entsprechender Weise und ggf. gleichzeitig mit den Schichten 30, 31 können das Heizelement 20 und die Leitungen 22 des Aktuators nach Fig. 10 mit ggf. unterschiedlichen Dotierungen ausgebildet, in der Halbleiterscheibe 26 vorzugsweise vergraben und dazu durch Tiefimplantation oder -diffusion hergestellt werden.

Nach weiteren Lithografie- und Ätzschritten zur Beseitigung eines zwischen den Fenstern 28, 29 verbliebenen $SiO_2$-Stegs 27a (Fig. 12) werden die beiden Schichten 30, 31 durch eine p-leitende Schicht 32 (Fig. 14) miteinander verbunden, die wie die Schichten 30 und 31, jedoch mit einer geringeren Dotierung aufgebracht und z. B. durch Aufheizen od. dgl. aktiviert wird und dann den piezoresistiven Detektor 12 (Fig. 8) bildet. Mit einer thermisch aufgebrachten $SiO_2$-Schutzschicht 33 werden die Schichten 30, 31 und 32 dann abgedeckt (Fig. 15).

Durch Anwendung analoger Verfahrensschritte (Lithografie, Oxid-Ätzen usw.) werden dann diejenigen Abschnitte der p+-Schichten 30, 31 frei gelegt, die mit Metallkontakten versehen werden sollen. Dadurch entstehende Kontaktlöcher sind in Fig. 15 mit dem Bezugszeichen 34 versehen. Dabei versteht sich, dass dann auf beiden Seiten der Schicht 32 Kontaktlöcher 34 angebracht werden, wenn nur eine solche Schicht 32 vorgesehen ist und/oder jede Schicht 32 mit beiden Seiten an je eine Kontaktfläche 16 (Fig. 1) od. dgl. angeschlossen werden soll. Da im Ausführungsbeispiel die beiden in Fig. 13 rechten Enden der Schichten 32 durch die p-leitende Schicht 31 verbunden werden, wird hier nur das in Fig. 15 linke Kontaktloch 34 benötigt.

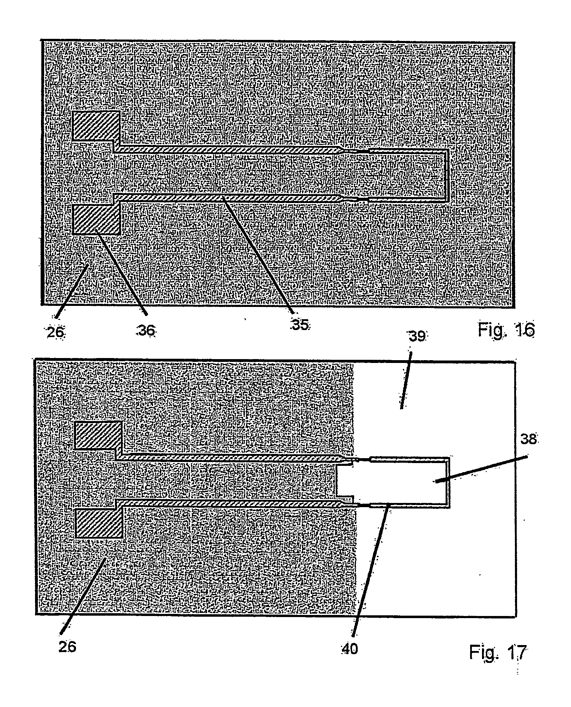

Im Anschluss daran wird die gesamte Oberfläche der Siliciumscheibe 26 mit einer Metallschicht 35, z. B. mit einer 0,8 $\mu$m dicken, durch Magnetronsputtern aufgebrachten Aluminiumschicht versehen, die danach mit einem geeigneten Ätzmittel (z. B. Phosphorsäure) überall dort weggeätzt wird, wo sie nicht benötigt wird. Es bleiben daher nur die eigentlichen Leitbahnen 35 und Kontaktflächen 36 (Fig. 16) stehen, die den Leiterbahnen 15 und Kontaktflächen 16 in Fig. 1 entsprechen. In entsprechender Weise können die Leiterbahnen 23 und Kontaktflächen nach Fig. 10 hergestellt werden.

Bei Bedarf kann zur Verbesserung der Kontaktierung eine weitere, sehr hoch dotierte Zone 37 (p++) in die Leitung 14 (Fig. 8) eingelassen werden, vorzugsweise durch verstärkte Bordiffusion.

In einem weiteren Verfahrensschritt wird jetzt die Einrichtung 3 hergestellt. Zu diesem Zweck werden von der oberen Breitseite der Siliciumscheibe 26 her mit Hilfe von weiteren Lithografie- und Ätzschritten Vertiefungen 38 und 39 (Fig. 17) ausgebildet. Die Vertiefung 38 wird dort ausgebildet, wo in Fig. 2 die Öffnung 7 vorhanden ist, während die Vertiefung 39 in demjenigen Teil der Oberfläche der Siliciumscheibe 26 angeordnet wird, der in Fig. 2 den U-förmigen Rahmen aus den Teilen 4, 5 und 6 umgibt. Die Vertiefungen 38, 39 erhalten z. B. eine Tiefe von 2 $\mu$m bis 10 $\mu$m, was der Dicke D des zweiten Elements 8 entspricht. Auf dem an dieser Stelle noch verbliebenen Teil der Siliciumscheibe 26 bleibt daher nach der Fertigstellung der Vertiefungen 38, 39 nur ein U-förmig umlaufender Steg 40 stehen, der erhaben vom Boden der Vertiefungen 38, 39 aufragt und die nach Fig. 11 bis 16 hergestellten Schichten 30 bis 32 enthält, die im fertigen Bauelement die Detektoren 12 und deren Anschlüsse bilden. Der Ätzschritt erfolgt dabei mit Ätzmitteln, die für $SiO_2$, Si und den am Schluss zu entfernenden Photoresist üblich sind.

Von der oberen Breitseite der verbliebenen Siliciumscheibe 26 her wird jetzt das zweite Element 8 aufgebracht. Dazu wird zunächst auf den Boden und die Wände der Vertiefungen 38, 39 eine 50 nm bis 100 nm dicke Schicht aus einem Ätzstop, z. B. Siliciumnitrid

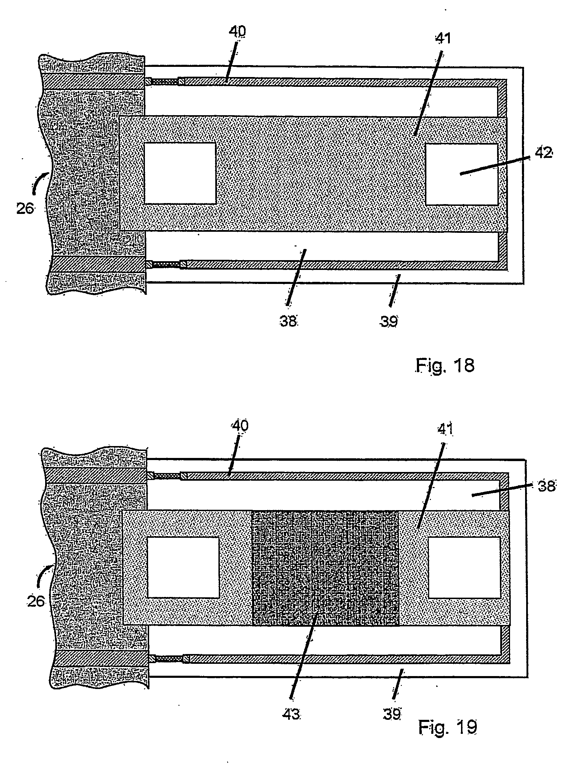

($Si_3N_4$), aufgebracht. Daran anschließend wird die Oberfläche der Siliciumscheibe 26 fotolithografisch maskiert und mit einem Fenster versehen, das nur denjenigen Teil der innerhalb des Stegs 40 befindlichen Vertiefung 38 frei lässt, der vom zweiten Element 8 unter Freilassung der Spalte mit der Breite a (Fig. 2) eingenommen werden soll. In die Vertiefung 38 wird dann eine später das zweite Element 8 bildende Materialschicht eingebracht. Im Falle von SU-8, das ein Polymer bzw. Lack ist und die Eigenschaften eines Negativresists hat, wird das Material in flüssiger Form aufgetragen. Nach einem Maskierungs- und Belichtungsschritt bleibt dann nur eine einen mittleren Teil der Vertiefung 38 ausfüllende Schicht 41 des Materials stehen, wie in Fig. 18 vergrößert anhand des den Steg 40 enthaltenden Teils der Siliciumscheibe 26 dargestellt ist. Bei Bedarf können durch eine entsprechende Maskierung Löcher 42 in der Schicht 41 vorgesehen werden, die den Löchern 11 nach Fig. 1 und 2 entsprechen.

Durch einen weiteren Lithografie- und Abscheidungsprozess wird dann eine Schicht 43 aus Gold od. dgl. auf der Schicht 41 abgeschieden. Diese Schicht 43 bildet den Absorber 10 nach Fig. 1 und 2.

Zur Fertigstellung des Bauelements wird die Siliciumscheibe 26 nun von ihrer Rückseite her in dem aus Fig. 18 und 19 ersichtlichen, noch die Vertiefungen 39 und teilweise auch die Vertiefung 38 aufweisenden Bereich geätzt, beispielsweise mit Kaliumhydroxid (kost). Der Ätzschritt wird zunächst so lange durchgeführt, bis der mit der $Si_3N_4$-Schicht versehene Bereich der Vertiefung 38 erreicht ist. Zu diesem Zeitpunkt ist das gesamte, in Fig. 17 unterhalb der Vertiefungen 38, 39 befindliche Siliciummaterial entfernt und nur noch der Steg 40 und die von diesem umrahmte Schicht 41 vorhanden. Der Ätzschritt wird dann noch eine Zeit lang fortgesetzt, um dadurch den Steg 41 auf ein dem Maß d (vgl. z. B. Fig. 4) entsprechendes Maß zu verdünnen. Die vorher am Boden der Vertiefung 38 abgeschiedene $Si_3N_4$-Schicht dient dabei als Ätzstop und verhindert, da sie gegenüber KOH restistent ist, dass durch den Ätzschritt auch der Boden und die Außenwände der Schicht 41 angegriffen und dadurch ebenfalls verdünnt werden. Am Ende des Ätzschritts besitzt daher der Steg 40 die Dicke d und die Schicht 41 die Dicke D (Fig. 4) entsprechend der Tiefe der Vertiefung 38.

Abschließend werden verbliebene $Si_3N_4$-Schichten z. B. mit Phosphorsäure selektiv entfernt, wodurch das anhand der Fig. 1 bis 9 beschriebene Bauelement fertig ist.

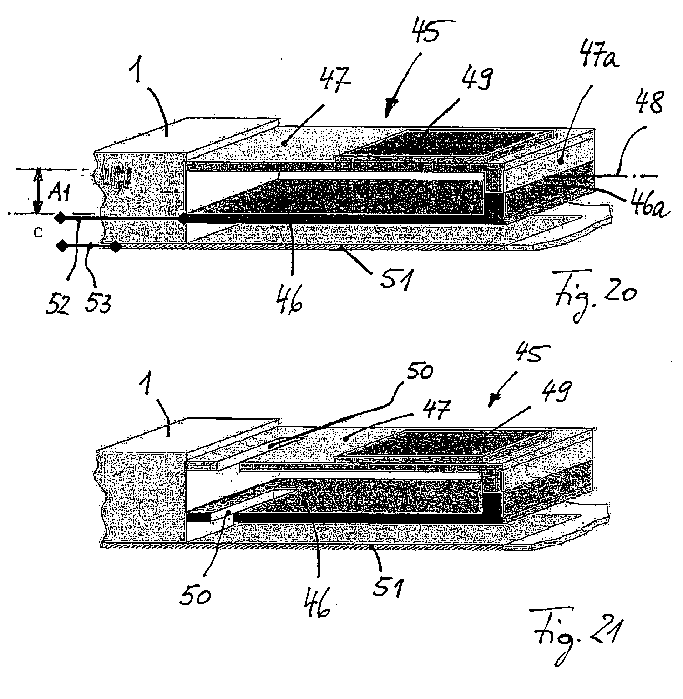

Fig. 20 und 21, in denen gleiche Teile mit denselben Bezugszeichen wie in Fig. 1 bis 10 versehen sind, zeigen ein zweites Ausführungsbeispiel des erfindungsgemäßen, mikrosystemtechnischen Bauelements. Dieses Bauelement enthält wie in Fig. 1 bis 9 den Grund- und Haltekörper 1, an dem ein Längsende einer verformbaren Einrichtung 45 starr befestigt ist, während das entgegengesetzte Längsende der Einrichtung 45 frei bewegbar angeordnet ist. Die Einrichtung 45 enthält wenigstens ein erstes biegbares Element 46 und wenigstens ein zweites biegbares Element 47. Beide Elemente 46, 47 bestehen vorzugsweise aus plattenförmigen und länglichen Bauteilen, die im wesentlichen gleich groß ausgebildet und entsprechend Fig. 20 und 21 parallel zueinander und parallel zu einer gemeinsamen, durch eine Linie angedeuteten Mittelebene 48 angeordnet sind. Außerdem sind beide Elemente 46, 47 mit einem lichten Abstand A1 voneinander angeordnet und an freien, vom Grundkörper 1 entfernten Enden durch einander zugewandte, die jeweilige Plattenoberfläche überragende Endabschnitte 46a, 47a fest miteinander verbunden. Diese Endabschnitte 46a, 47a wirken gleichzeitig als Abstandhalter, so dass der Abstand A1 über die ganze Breite und Länge der Elemente 46, 47 vorzugsweise konstant ist. Dabei versteht sich, dass die Verbindung der Elemente 46, 47 auch durch andere Mittel als die Endabschnitte 46a, 47a vorgenommen werden könnte. Schließlich zeigen Fig. 20 und 21, dass die Elemente 46, 47 parallel zur Mittelebene 48 vergleichsweise lang und breit sind, senkrecht dazu aber eine vergleichsweise kleine Dicke aufweisen, so dass die Einrichtung 45 wie ein einseitig eingespannter Biegebalken wirkt.

Wie in Fig. 1 bis 19 besitzen das erste und das zweite Element 46, 47 unterschiedliche Ausdehnungskoeffizienten und Wärmeleitfähigkeiten. Insbesondere können die Elemente 46, 47 aus denselben Materialien bestehen, wie oben anhand der Fig. 1 bis 19 für die ersten Elemente 4, 5 und die zweiten Elemente 8 beschrieben wurde. Danach besteht das erste Element 46 z. B. aus einem Halbleitermaterial wie Silicium, das zweite Element 47 dagegen z. B. aus einem Polymer, insbesondere dem oben erläuterten Material SU-8. Schließlich wird vorzugsweise die vom ersten Element 46 abgewandte obere Breitseite des zweiten Elements 47 mit einem dem Absorber 10 nach Fig. 1 und 2 entsprechenden Absorber 49 belegt.

Beim Erwärmen des zweiten Elements 47 bzw. des Absorbers 49 durch eine Strahlung, insbesondere eine IR-Strahlung, dehnen sich analog zu Fig. 9 die beiden Elemente 46, 47 unterschiedlich stark aus, wodurch sich die verformbare Einrichtung 45 quer zur Mittelebene 48 bzw. in Richtung der Dicke der Elemente 46, 47 nach oben oder unten, im Ausführungsbeispiel vorwiegend nach unten verbiegt. Um zu vermeiden, dass die aufgenommene Wärme zum Grundkörper 1 abfließt, können die Elemente 46, 47 mit Ausnehmungen bzw. Löchern 50 (Fig. 21) versehen sein, die dieselbe Wirkung wie die anhand der Fig. 1 bis 19 beschriebenen Löcher 11 haben. Im übrigen gilt hinsichtlich der Ausbildung und der Herstellung des Bauelements nach Fig. 20 und 21 im wesentlichen dasselbe wie für das Bauelement nach Fig. 1 bis 19.

Zur Messung der Verbiegung der Einrichtung 45 nach Fig. 20 und 21 ist abweichend von der auch hier möglichen Messung mit piezoresistiven Detektoren eine kapazitive Messmethode beispielhaft dargestellt. Hierzu ist einerseits auf der vom zweiten Element 47 abgewandten Breitseite des ersten Elements 46 eine zusätzliche, plattenförmige, zu den Elementen 46, 47 parallele und vergleichsweise biegesteife Metallelektrode 51 angeordnet und am Grundkörper 1 befestigt. Andererseits ist das erste Element 46 entweder durchgehend aus einem Metall hergestellt oder auf der der Metallelektrode 51 zugewandten Breitseite mit einer elektrisch leitenden Schicht versehen, die z. B. auch durch eine hohe Dotierung des Halbleitermaterials erhalten werden kann. Dadurch bilden das Element 46 und die Metallelektrode 51 die beiden Platten eines Kondensators, dessen Kapazitität sich mit deren Abstand, d. h. mit dem durch Wärmeeinfluss erzeugten Biegezustand der Einrichtung 45 ändert. Diese Kapazitätsänderung kann mit Hilfe allgemein bekannter Messmethoden ermittelt werden, indem das Element 47 und die Metallelektrode 51 über geeignete Zuleitungen 52, 53 mit elektrischen Strömen und/oder Spannungen beaufschlagt werden.

Das Bauelement nach Fig. 20 und 21 kann wie das Bauelement nach Fig. 10 als Aktuator verwendet werden, indem z. B. das zweite Element 47 mit einem elektrischen Heizelement versehen wird.

Die Erfindung ist nicht auf die beschriebenen Ausführungsbeispiele beschränkt, die auf vielfache Weise abgewandelt werden können. Dies gilt insbesondere für die angegebenen Formen, Abmessungen und Materialien der erfindungsgemäßen Bauelemente.

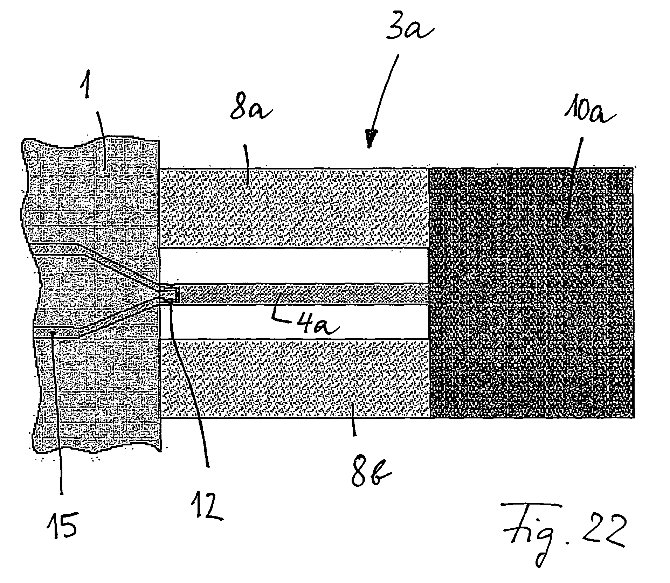

Auch die Form des Rahmens kann eine andere sein. Beispielsweise könnte der Rahmen in der Draufsicht quadratisch, halbkreisförmig, halbelliptisch, dreieckig oder sonstwie anstatt rechteckig wie in Fig. 2 ausgebildet sein. Ferner könnte eines der Elemente 4, 5 ganz fehlen. Möglich wäre es auch, den Rahmen einer verformbaren Einrichtung 3a entsprechend Fig. 22, in der gleiche Teile mit denselben Bezugszeichen wie in Fig. 1 und 2 versehen sind, mit zwei zweiten Elementen 8a und 8b zu bilden, deren freie Enden mit einem dem Endabschnitt 6 (z. B. Fig. 2) entsprechenden Endabschnitt verbunden werden, und im mittleren Teil des Rahmens wenigstens ein erstes Element 4a dort anzuordnen, wo im Ausführungsbeispiel nach Fig. 1 bis 19 das Element 8 liegt. Ein Absorber 10a (bzw. ein Heizelement) könnte in diesem Fall an dem die Elemente 8a, 8b verbindenden Endabschnitt vorgesehen sein. Die Auslenkung der Einrichtung 3a erfolgt dabei ebenfalls im wesentlichen senkrecht zur Mittelebene des aus den Teilen 8a, 8b und 4a gebildeten Rahmens. Wie im Fall der Fig. 1 bis 9 sind dabei die zweiten Elemente 8a, 8b vorzugsweise breiter und dicker als das erste Element 4a.

Als Materialien für das zweite Element 8, 8a, 8b kommen außer dem bevorzugten SU-8 auch zahlreiche andere Materialien in Frage, insbesondere verschiedene Polymere wie z. B. Polypropylen, Polyethylen und Polystyrol, die im Vergleich zu SU-8 größere thermische Ausdehnungskoeffizienten und teilweise auch kleinere Wärmeleitfähigkeiten haben. Weiter dient das beschriebene Herstellungsverfahren nur als Beispiel, da es zahlreiche andere Methoden zur Herstellung der Bauelemente und von deren Teilen gibt. Weiter werden die verschiedenen Bauelemente vorzugsweise nicht einzeln, sondern in großen Stückzahlen gleichzeitig auf einer gemeinsamen Siliciumscheibe hergestellt. Außerdem versteht sich, dass die verschiedenen Merkmale auch in anderen als den dargestellten und beschriebenen Kombinationen angewendet werden können.

Die Erfindung wird in den beigefügten Ansprüchen definiert.

## Patentansprüche

1. Mikrosystemtechnisches, als Strahlungssensor oder Biegebalken-Aktuator ausgebildetes Bauelement mit einer unter dem Einfluss von Temperaturänderunge verformbaren Einrichtung (3), die wenigstens je ein erstes und zweites biegbares Element (4, 5; 8) enthält, wobei diese Elemente (4, 5; 8) unterschiedliche thermische Ausdehnungskoeffizienten und unterschiedliche Wärmeleitfähigkeiten haben und mit jeweils einem ersten Ende an einem Grundkörper (1) starr fixiert, an entgegengesetzten zweiten Enden dagegen frei beweglich und so angeordnet und miteinander verbunden sind, dass sie von den Temperaturänderungen abhängige Biegezustände einnehmen, **dadurch gekennzeichnet, dass** die beiden Elemente (4, 5; 8) mit Abstand (a, A1) voneinander angeordnet und an ihren zweiten in Richtung einer Längsachse (2) vom Grundkörper (1) beabstandeten Enden durch wenigstens einen Endabschnitt (6; 46a, 47a) fest miteinander verbunden sind, so daß der Endabschnitt bei Temperaturänderungen eine Auslenkung quer zur Längsachse (2) erfährt.

2. Bauelement nach Anspruch 1, **dadurch gekennzeichnet, dass** es als Sensor zur Messung von durch elektromagnetische Strahlung bewirkten Temperaturänderungen eingerichtet ist.

3. Bauelement nach Anspruch 2, **dadurch gekennzeichnet, dass** der Sensor als IR-Sensor ausgebildet ist.

4. Bauelement nach Anspruch 2 oder 3, **dadurch gekennzeichnet, dass** zumindest eines der beiden Elemente (4, 5; 8 bzw. 46, 47) mit einem Absorber (10, 49) für die Strahlung versehen ist.

5. Bauelement nach Anspruch 1, **dadurch gekennzeichnet, dass** es als ein durch Temperaturänderungen betätigbarer Aktuator eingerichtet ist.

6. Bauelement nach Anspruch 5, **dadurch gekennzeichnet, dass** zumindest eines der Elemente (4, 5; 8 bzw. 46, 47) mit einem Heizelement (20) versehen ist.

**7.** Bauelement nach einem der Ansprüche 1 bis 6, **dadurch gekennzeichnet, dass** er zwei erste, mit Abstand voneinander angeordnete Elemente (4, 5) enthält, die an einem Ende starr fixiert und an einem anderen, frei bewegbaren Ende unter Bildung eines Rahmens durch einen Endabschnitt (6) miteinander verbunden sind.

**8.** Bauelement nach Anspruch 7, **dadurch gekennzeichnet, dass** das zweite Element (8) zwischen den beiden ersten Elementen (4, 5) angeordnet und an einem Ende starr fixiert, an einem anderen Ende dagegen mit dem Endabschnitt (6) verbunden ist.

**9.** Bauelement nach Anspruch 7 oder 8, **dadurch gekennzeichnet, dass** der Rahmen eine rechteckige Grundform aufweist.

**10.** Bauelement nach einem der Ansprüche 7 bis 9, **dadurch gekennzeichnet, dass** die Elemente (4, 5, 8) so ausgebildet sind, dass die Einrichtung (3) quer zu einer Mittelebene des Rahmens verbogen wird.

**11.** Bauelement nach einem der Ansprüche 1 bis 6, **dadurch gekennzeichnet, dass** die beiden Elemente (46, 47) plattenförmig ausgebildet, mit einem Abstand (A1) parallel zueinander angeordnet, an einem Ende starr fixiert und an einem anderen, frei bewegbaren Ende fest miteinander verbunden sind.

**12.** Bauelement nach Anspruch 11, **dadurch gekennzeichnet, dass** die Einrichtung (45) quer zu einer gemeinsamen Mittelebene (48) der Elemente (46, 47) verbogen wird.

**13.** Bauelement nach einem der Ansprüche 1 bis 12, **dadurch gekennzeichnet, dass** jedes erste Element (4, 5) eine wesentlich kleinere Breite (b) als das zweite Element (8) aufweist.

**14.** Bauelement nach Anspruch 13, **dadurch gekennzeichnet, dass** jedes erste Element (4, 5) eine Breite (b) aufweist, die wenigstens um das 10-fache kleiner als die Breite (B) des zweiten Elements (8) ist.

**15.** Bauelement nach einem der Ansprüche 1 bis 14, **dadurch gekennzeichnet, dass** jedes erste Element (4, 5, 46) eine kleinere Dicke (d) als das zweite Element (8, 47) aufweist.

**16.** Bauelement nach einem der Ansprüche 1 bis 15, **dadurch gekennzeichnet, dass** das zweite Element (8, 47) einen größeren thermischen Ausdehnungskoeffizienten und eine kleinere Wärmeleitfähigkeit als das erste Element (4, 5, 46) bzw. die ersten Elemente hat.

**17.** Bauelement nach einem der Ansprüche 4 bis 16, **dadurch gekennzeichnet, dass** das zweite Element (8, 47) mit dem Absorber (10, 49) versehen ist und dieser eine hohe Wärmeleitfähigkeit aufweist.

**18.** Bauelement nach Anspruch 17, **dadurch gekennzeichnet, dass** das zweite Element (8, 47) in wenigstens einem zwischen dem Absorber (10, 49) und einem der Enden liegenden Bereich ein zur thermischen Isolierung bestimmtes Loch (11, 50) aufweist.

**19.** Bauelement nach einem der Ansprüche 1 bis 18, **dadurch gekennzeichnet, dass** wenigstens ein erstes Element (4, 5, 46) mit wenigstens einem piezoresistiven, zur Messung seines Biegezustands bestimmten Detektor (12) versehen ist.

**20.** Bauelement nach einem der Ansprüche 1 bis 19, **dadurch gekennzeichnet, dass** ihm eine zur kapazitiven Ermittlung des Biegezustand der Einrichtung (3, 45) bestimmte Elektrode (51) zugeordnet ist.

**21.** Bauelement nach einem der Ansprüche 1 bis 20, **dadurch gekennzeichnet, dass** wenigstens ein erstes Element (4, 5) aus Silicium besteht.

**22.** Bauelement nach einem der Ansprüche 1 bis 21, **dadurch gekennzeichnet, dass** das zweite Element (8, 47) aus einem Polymer, insbesondere einem Epoxidharz besteht.

**23.** Bauelement nach Anspruch 22, **dadurch gekennzeichnet, dass** das Epoxidharz einen thermischen Ausdehnungskoeffizienten von ca. $52 \cdot 10^{-6} \cdot K^{-1}$ und eine Wärmeleitfähigkeit von ca. 0,2 W/mK hat.

**24.** Bauelement nach einem der Ansprüche 4 bis 23, **dadurch gekennzeichnet, dass** der Absorber (10, 49) aus einem für eine vorgewählte Wellenlänge der Strahlung empfindlichen Material besteht.

**25.** Bauelement nach einem der Ansprüche 4 bis 24, **dadurch gekennzeichnet, dass** der Absorber (10, 49) aus Gold besteht.

**Claims**

**1.** Microsystems component configured as a radiation sensor or bending beam actuator with an arrangement (3), which is deformable under the influence of temperature changes and which contains at least one respective first and second bendable element (4, 5; 8), wherein these elements (4, 5; 8) have different coefficients of thermal expansion and different thermal conductivities and are rigidly secured to a base body (1) at a respective first end, whereas at the opposite second end they are movably arranged and connected to one another so that they assume bending states dependent on the temperature changes, **characterised in that** the two elements (4, 5; 8) are arranged at a distance (a, A1) from one another and at their second ends, which are spaced from the base body (1) in the direction of a longitudinal axis (2), are fixedly connected to one another by at least one end section (6; 46a, 47a), so that the end section undergoes a deflection transversely to the longitudinal axis (2) in the case of temperature changes.

2. Component according to claim 1, **characterised in that** it is fitted as a sensor for measuring temperature changes caused by electromagnetic radiation.

3. Component according to claim 2, **characterised in that** the sensor is configured as an IR sensor.

4. Component according to claim 2 or 3, **characterised in that** at least one of the two elements (4, 5; 8 or 46, 47) is provided with an absorber (10, 49) for the radiation.

5. Component according to claim 1, **characterised in that** it is fitted as an actuator, which can be actuated as a result of temperature changes.

6. Component according to claim 5, **characterised in that** at least one of the elements (4, 5; 8 or 46, 47) is provided with a heating element (20).

7. Component according to one of claims 1 to 6, **characterised in that** it contains two first elements (4, 5), which are spaced from one another, are rigidly secured at one end and at another freely movable end are connected to one another by an end section (6) to form a frame.

8. Component according to claim 7, **characterised in that** the second element (8) is arranged between the two first elements (4, 5) and is rigidly secured at one end, but is connected to the end section (6) at another end.

9. Component according to claim 7 or 8, **characterised in that** the frame has a rectangular basic form.

10. Component according to one of claims 7 to 9, **characterised in that** the elements (4, 5; 8) are configured so that the arrangement (3) is bent transversely to a centre plane of the frame.

11. Component according to one of claims 1 to 6, **characterised in that** the two elements (46, 47) are plate-shaped, are spaced parallel to one another at a distance (A), are rigidly secured at one end and fixedly connected to one another at another freely movable end.

12. Component according to claim 11, **characterised in that** the arrangement (3) is bent transversely to a common centre plane (48) of the elements (46, 47).

13. Component according to one of claims 1 to 12, **characterised in that** each first element (4, 5) has a substantially smaller width (b) than the second element (8).

14. Component according to claim 13, **characterised in that** each first element (4, 5) has a width (b), which is at least 10-times smaller than the width (B) of the second element (8).

15. Component according to one of claims 1 to 14, **characterised in that** each first element (4, 5, 46) has a smaller thickness (d) than the second element (8, 47).

16. Component according to one of claims 1 to 15, **characterised in that** the second element (8, 47) has a higher coefficient of thermal expansion and a lower thermal conductivity than the first element (4, 5, 46) or first elements.

17. Component according to one of claims 4 to 16, **characterised in that** the second element (8, 47) is provided with the absorber (10, 49) and this has a high thermal conductivity.

18. Component according to claim 17, **characterised in that** in at least one region located between the absorber (10, 49) and one of the ends, the second element (8, 47) has a hole (11, 50) intended for thermal insulation.

19. Component according to one of claims 1 to 18, **characterised in that** at least one first element (4, 5, 46) is provided with at least one piezoresistive detector (12) intended for measuring its bending state.

20. Component according to one of claims 1 to 19, **characterised in that** it has an associated electrode (51) intended for capacitive determination of the bending state of the arrangement (3, 45).

21. Component according to one of claims 1 to 20, **characterised in that** at least one first element (4, 5) is made of silicon.

22. Component according to one of claims 1 to 21, **characterised in that** the second element (8, 47) is made of a polymer, in particular an epoxy resin.

23. Component according to claim 22, **characterised in that** the epoxy resin has a coefficient of thermal expansion of approximately $52 \cdot 10^{-6} \cdot K^{-1}$ and a thermal conductivity of approximately 0.2 W/mK.

**24.** Component according to one of claims 4 to 23, **characterised in that** the absorber (10, 49) is made of a material sensitive to a preselected wavelength of the radiation.

**25.** Component according to one of claims 4 to 24, **characterised in that** the absorber (10, 49) is made of gold.

**Revendications**

**1.** Composant de la technique des microsystèmes, réalisé sous forme de capteur de rayonnement ou d'actionneur à poutre de flexion, pourvu d'un dispositif (3) déformable sous l'effet de variations de température, qui contient au moins un premier et un deuxième élément flexible (4, 5 ; 8), ces éléments (4, 5 ; 8) ayant différents coefficients de dilatation thermiques et différentes conductibilités thermiques et étant chaque fois fixés rigidement par une première extrémité à un corps de base (1), de manière librement mobile par contre à de deuxièmes extrémités opposées et étant disposés et reliés ensemble de manière qu'il prennent des états de flexion dépendant des variations de température, **caractérisé en ce que** les deux éléments (4, 5 ; 8) sont disposés à distance (a, A1) l'un de l'autre et reliés ensemble de manière fixe à leurs deuxièmes extrémités, éloignées du corps de base (1) dans la direction d'un axe longitudinal (2), par au moins une section terminale (6 ; 46a, 47a) de manière que la section terminale subisse une déviation transversalement à l'axe longitudinal (2) en cas de variations de température.

**2.** Composant selon la revendication 1, **caractérisé en ce qu'**il est conçu comme capteur servant à mesurer les variations de température provoquées par un rayonnement électromagnétique.

**3.** Composant selon la revendication 2, **caractérisé en ce que** le capteur est réalisé sous forme de capteur IR.

**4.** Composant selon la revendication 2 ou 3, **caractérisé en ce qu'**au moins un des deux éléments (4, 5 ; 8 ou 46, 47) est pourvu d'un absorbeur (10, 49) pour le rayonnement.

**5.** Composant selon la revendication 1, **caractérisé en ce qu'**il est conçu comme actionneur pouvant être commandé par des variations de température.

**6.** Composant selon la revendication 5, **caractérisé en ce qu'**au moins un des éléments (4, 5 ; 8 ou 46, 47) est pourvu d'un élément chauffant (20).

**7.** Composant selon l'une des revendications 1 à 6, **ca-** ractérisé en ce qu'**il contient deux premiers éléments (4, 5) disposés à distance l'un de l'autre, qui sont fixés rigidement à une extrémité et reliés ensemble à une autre extrémité librement mobile par une section terminale (6) de manière à former un cadre.

**8.** Composant selon la revendication 7, **caractérisé en ce que** le deuxième élément (8) est disposé entre les deux premiers éléments (4, 5) et fixé rigidement à une extrémité, relié par contre à la section terminale (6) à une autre extrémité.

**9.** Composant selon la revendication 7 ou 8, **caractérisé en ce que** le cadre présente une forme de base rectangulaire.

**10.** Composant selon l'une des revendications 7 à 9, **caractérisé en ce que** les éléments (4, 5, 8) sont réalisés de manière que le dispositif (3) soit déformé transversalement à un plan médian du cadre.

**11.** Composant selon l'une des revendications 1 à 6, **caractérisé en ce que** les deux éléments (46, 47) sont réalisés en forme de plaque, disposés parallèlement l'un à l'autre à une distance (A1), fixés rigidement à une extrémité et reliés ensemble de manière fixe à une autre extrémité librement mobile.

**12.** Composant selon la revendication 11, **caractérisé en ce que** le dispositif (45) est déformé transversalement à un plan médian commun (48) des éléments (46, 47).

**13.** Composant selon l'une des revendications 1 à 12, **caractérisé en ce que** chaque premier élément (4, 5) présente une largeur (b) beaucoup plus petite que le deuxième élément (8).

**14.** Composant selon la revendication 13, **caractérisé en ce que** chaque premier élément (4, 5) présente une largeur (b) qui est au moins 10 fois plus petite que la largeur (B) du deuxième élément (8).

**15.** Composant selon l'une des revendications 1 à 14, **caractérisé en ce que** chaque premier élément (4, 5, 46) présente une épaisseur (d) plus petite que le deuxième élément (8, 47).

**16.** Composant selon l'une des revendications 1 à 15, **caractérisé en ce que** le deuxième élément (8, 47) a un coefficient de dilatation thermique plus grand et une conductibilité thermique plus petite que le premier élément (4, 5, 46), respectivement les premiers éléments.

**17.** Composant selon l'une des revendications 4 à 16, **caractérisé en ce que** le deuxième élément (8, 47) est pourvu de l'absorbeur (10, 49) et celui-ci présente une conductibilité thermique élevée.

**18.** Composant selon la revendication 17, **caractérisé en ce que** le deuxième élément (8, 47) présente un trou (11, 50) destiné à l'isolation thermique dans au moins une région située entre l'absorbeur (10, 49) et une des extrémités.

**19.** Composant selon l'une des revendications 1 à 18, **caractérisé en ce qu'**au moins un premier élément (4, 5, 46) est pourvu d'au moins un détecteur piézorésistif (12) destiné à la mesure de son état de flexion.

**20.** Composant selon l'une des revendications 1 à 19, **caractérisé en ce qu'**une électrode (51) destinée à la détermination capacitive de l'état de flexion du dispositif (3, 45) lui est associée.

**21.** Composant selon l'une des revendications 1 à 20, **caractérisé en ce qu'**au moins un premier élément (4, 5) est en silicium.

**22.** Composant selon l'une des revendications 1 à 21, **caractérisé en ce que** le deuxième élément (8, 47) est composé d'un polymère, en particulier d'une résine époxy.

**23.** Composant selon la revendication 22, **caractérisé en ce que** la résine époxy a un coefficient de dilatation thermique d'environ $52 \cdot 10^{-6} \cdot K^{-1}$ et une conductibilité thermique d'environ 0,2 W/mK.

**24.** Composant selon l'une des revendications 4 à 23, **caractérisé en ce que** l'absorbeur (10, 49) est composé d'un matériau sensible à une longueur d'onde présélectionnée du rayonnement.

**25.** Composant selon l'une des revendications 4 à 24, **caractérisé en ce que** l'absorbeur (10, 49) est en or.

Fig. 1

Fig.2

Fig. 3

Fig. 4

Fig. 5

Fig. 6

Fig. 7

EP 1 834 162 B1

Fig. 8

EP 1 834 162 B1

EP 1 834 162 B1

Fig. 9

Fig. 10

Fig. 11

Fig. 12

Fig. 13

Fig. 14

Fig. 15

26    36    35    39    Fig. 16

26    40    38    39    Fig. 17

Fig. 18

Fig. 19

Fig. 20

Fig. 21

*Fig. 22*

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- WO 0040938 A
- US 20010052570 A
- US 6805839 B2
- DE 10307561 A1
- US PS4882245 A

### In der Beschreibung aufgeführte Nicht-Patentliteratur

- **P. G. DATSKOS ; N. V. LAVRIK ; S. RAJIC.** Performance of uncooled microcantilever thermal detectors. *Review of Scientific Instruments,* April 2004, vol. 75 (4), 1134-1148
- **REICHL et al.** Halbleitersensoren. expert-Verlag, 1989, 225
- **T. GOTSZALK ; J. RADOJEWSKI ; P. B. GRABIEC ; P. DUMALIA ; F. SHI ; P. HUDEK ; I. W. RANGELOW.** Fabrication of multipurpose piezoresistive Wheatstone bridge cantilevers with conductive microtips for electrostatic and scanning capacitance microscopy. *J. Vac. Sci. Technol. B,* November 1998, vol. 16 (6), 3948-3953
- **I. W. RANGELOW ; P. B. GRABIEC ; T. GOTSZALK ; K. EDINGER.** Piezoresistive SXM Sensors. *SIA,* 2002, vol. 1162, 3948-3953